# EUROPEAN PATENT APPLICATION

(11) **EP 1 081 857 A1**
(43) Date of publication of application: **07.03.2001**
(21) Application number: 99117381.6
(22) Date of filing: 03.09.1999
(51) Int. Cl.: H03K 3/037, H03K 3/356, G06F 1/10

(54) **Method for operating an ASIC device, Asic device and flip flop for use in the Asic device**

(71) Applicant: LSI LOGIC CORPORATION, Milpitas, CA 95035 (US)
(72) Inventor: Block, Stefan, 81825 München (DE)
(74) Representative: Kirschner, Klaus Dieter, Dipl.-Phys.

(57) **Abstract**

A method for operating an ASIC device and an ASIC device having a clock driver (12), a clock tree system (2 to 10) and load circuits (18, 24) being supplied with a clock signal from the clock driver through the clock tree system the clock signal having clock pulses with a rising and a falling edge, comprises providing flip flops which are operated by both edges of the clock pulses, as load circuits (18, 24) and supplying a clock signal having a duty cycle twice as long as the pulse width of the clock pulses. The frequency of the clock pulses can be reduced by one half while maintaining the same functionality in the ASIC device.

## Description

The invention relates to a method for operating an ASIC device having a clock driver, a clock tree system and load circuits being supplied with a clock signal having clock pulses with a rising and a falling edge, from the clock driver through the clock tree system.

The invention further relates to an ASIC device making use of the above method, as well as a flip flop for use in an ASIC device of the before mentioned type.

There is a trend in the market in the sense that ASIC devices are becoming more and more power sensitive. As the geometries are becoming ever smaller, ASIC devices having more than 500 K gates are becoming the norm. Furthermore, there is a trend that the ASIC devices are incorporating ever more logic functions. Additionally, the frequencies of operation for such ASIC devices are also increasing. This, in turn, results in ASIC devices that consume more and more power. For such ASIC devices in the area of laptop computing and wireless communication as well as in many consumer products, the biggest cost factor nowadays is the power consumption. Therefore, new designs of ASIC devices have to be developed in order to save power.

One attempt to save power was to turn off sections of the logic circuitry that are not active, and to allow the sections of the circuitry to be active only when needed. Among others, power can be saved by putting logic circuitry to a "sleep" mode with an interrupting mechanism to "wake up" the logic circuitry when needed or to run the different domains of the ASIC device with as low clock frequencies as possible. However, the last mentioned possibility poses the problem that the various clock signals having different frequencies have to by synchronized, and such a synchronization is impaired by the skew effect which comes about because of the difference in time that the clock signals need to reach the flip flop which is nearest to the clock driver as compared to the time needed for the clock signals to arrive at the flip flop which is the most distant from the clock driver.

Another attempt to save power is to design new clock tree systems that are expected to save power. This concept was tried with the single ended driver scheme, the double ended driver scheme, the local buffering scheme and the H-tree scheme which schemes have been developed to assure, in a particular chip, that the skew on the clock signal lines does not exceed a maximum value which depends on the particular technology used.

To summarize the above, all attempts to save power on ASIC devices have been directed to improving the clock tree system, and some attempts have lead to additional problems as discussed with respect to skew above.

In view of the above, it is a main object of the invention to provide a method for operating an ASIC device which serves to reduce power consumption.

It is another object of the invention to provide an ASIC device making use of the above method in which power is saved as much as possible.

It is a further object of the invention to provide a flip flop which is adapted to be used in an ASIC device of the kind mentioned above.

For solving the first mentioned object, a method for operating an ASIC device having a clock driver, a clock tree system and load circuits being supplied with a clock signal from the clock driver through the clock tree system, the clock signal having clock pulses with a rising and a falling edge, which method comprises:
- providing flip flops which are operated by both edges of the clock pulses, as load circuits and
- supplying a clock signal having a duty cycle twice as long as the pulse width of the clock pulses.

By means of this method. the frequency of the clock pulses can be reduced by one half while maintaining the same functionality in the ASIC device. Due to the fact that about 5 % of the chip power is consumed by the clock tree system, the power consumption can be reduced if the frequency of the clock pulses of the clock-speed in the clock tree can be reduced by one half as compared to the case where flip flops are used which work only on one edge, for example the rising edge, of the clock pulse. In other words, if the flip flops which form the load circuits, are operated with the same frequency using flip flops operating on both edges of the clock pulses reduces the power consumption while having the same functionality as an ASIC device being clocked with the double frequency and using flip flops operated only by one edge of the clock pulse. However, if one maintains the clock frequency and uses the flip flops being operated by both edges of the clock pulse, the frequency of operation of the flip flops is doubled and the power consumption is not increased. As the operation of the flip flop which works on both edges of the clock pulse depends on the duty cycle of the clock pulse, the duty cycle of the clock pulse has to be selected twice as long as the pulse width of the clock pulses which is no problem in such circuits.

To solve the second mentioned object, an ASIC device having a clock driver, a clock tree system and load circuits being supplied with a clock signal from the clock driver through the clock tree system, the clock signal having clock pulses with a rising and a falling edge, comprises flip flops which are operated by both edges of the clock pulses, as load circuit devices, and a clock driver which is designed such that it supplies a clock signal having a duty cycle twice as long as the pulse width of the clock pulses. As mentioned above, it is possible in such an ASIC device to save considerable power without losing functionality.

The above-mentioned third object is solved by a flip flop for use in an ASIC device having a clock driver, a clock tree system and load circuits being supplied with a clock signal having clock pulses with a rising and a falling edge, from the clock driver through the clock tree system, the flip flop being adapted to be operated by both edges of the clock pulses. This design of the flip flop according to one embodiment of the invention has the advantage of being the reason for savings in the power consumption of the ASIC device as a whole.

An advantageous embodiment of the flip flop consists in that the flip flop comprises two latch circuits connected in parallel to each other, and a multiplexer circuit, one of the latch circuits becoming transparent on occurrence of the rising edge of the clock pulse, the other one of the latch circuits becoming transparent on occurrence of the falling edge of the clock pulse, and the multiplexer circuit being supplied at its inputs with output signals of the latch circuits and being clocked by the clock signal. This circuitry being a simple and efficient way to embody the flip flop which is operated by both edges of the clock pulses.

A further advantageous embodiment of the flip flop consists in that transparent D-flip flops are used for the latch circuits.

A further advantageous embodiment of the invention can be seen from the following specification.

Embodiments of the invention are now described with reference to the accompanying drawings in which:
- Figure 1: is an example of a clock tree system and the load circuits on an ASIC device;
- Figure 2: is a schematic block diagram of a flip flop according to one embodiment of the invention;
- Figure 3: is a clock signal used for operating the flip flops of figures 2 and 3; and
- Figure 4: is a more detailed circuit diagram of the flip flop of figure 2.

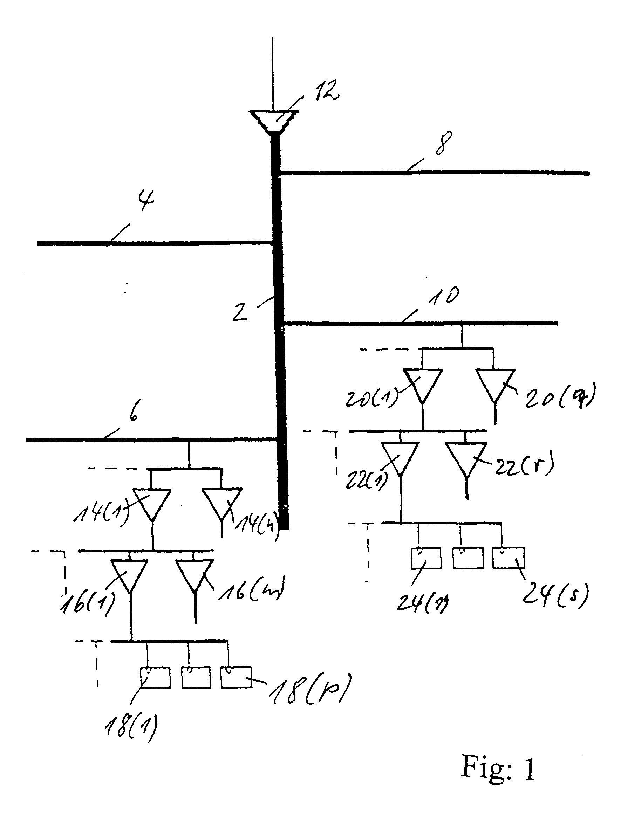

Figure 1 shows a conventional BCT (balanced clock tree) system for distributing the clock signals in a clock tree system on a chip or in an ASIC device. The BCT system includes a clock trunk or master clock line 2 and branched clock lines 4, 6, 8, 10, so-called tributaries. In such a single-ended clock system, the main clock line 2 is fed from a clock driver 12. Through the tributaries, for example from tributary 6, the clock signals are supplied to a first level of buffers 14(1) ... 14(n), from there to another level of buffers 16(1) ... 16(m) and from there to the loads of this domain, which are, in the shown example, flip flops 18(1) ... 18(p).

The same structure or circuit set up is to be found identically also in the domain of tributary 10, the clock signals are supplied to a first level of buffers 20(1) ... 20(q), from there to another level of buffers 22(1) ... 22(r) and from there to the loads of this domain which are, in the shown example, flip flops 24(1) ... 24(s). If n = q, m = r and p = s, so that the same number of buffers or loads are in the same level of the tributary 6 and the tributary 10, the respective domains are identical and the branched clock lines 6, 10 are balanced with respect to the delays and loads. However, as concerns power consumption, the power consumption of such circuitry arrangement increases with increasing frequency of the clock pulses. Therefore, one can save power by reducing the clock pulse frequency.

In order to reduce the clock pulse frequency in an ASIC device according to figure 1 having a clock driver 12, a clock tree system 2 and load circuits 18, 24, which load circuits are supplied with a clock signal having clock pulses with a rising and a falling edge, which are supplied from the clock driver 12 through the clock tree system 2, according to an embodiment of the invention, there are provided, as load devices, transparent D-flip flops which are operated by both edges of the clock pulses. These flip flops 18, 24 are supplied with a clock signal having a duty cycle 2d twice as long as the pulse width d of the clock pulses to maintain a proper timing of the operation of the flip flops 18, 24.

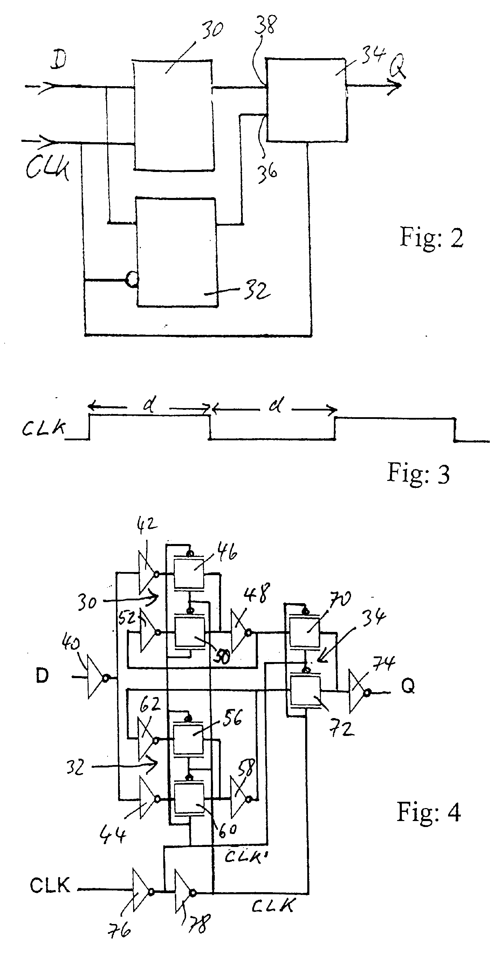

Figure 2 shows a block diagram of a transparent D-flip flop 18 for use in an ASIC device as described above and shown in figure 1. The D-flip flop 18 which is adapted to be operated by both edges of the clock pulses comprises two latch circuits 30, 32 and a multiplexer circuit 34. The latch circuits are connected in parallel to each other which means that one of the latch circuits 30 becomes transparent on occurrence of the rising edge of the clock pulse CLK applied thereto, and the other one of the latch circuits 32 becomes transparent on occurrence of the falling edge of the clock pulse CLK applied thereto. The multiplexer circuit 34 is supplied at its inputs 36, 38 with output signals of the latch circuits 30, 32, and the multiplexer circuit 34 is clocked by the same clock signal CLK as the latch circuits 30, 32. The data signal D is supplied to both latch circuits 30, 32. With such a circuit arrangement, the output signal Q of the multiplexer circuit 34 corresponds to the input data signal D as either the latch circuit 30 or the latch circuit 32 are always transparent for the data signal D.

As a matter of course, only one of the latch circuits 30 and 32 is transparent at a given time.

The flip flop of figure 2 comprises the following truth table:

| **CLK** | **D** | **Q** |
|---|---|---|
| 0 | X | Q - 1 |
| 1 | X | Q - 1 |
| 0 → 1 | 1 | 1 |
| 0 → 1 | 0 | 0 |
| 1 → 0 | 1 | 1 |
| 1 → 0 | 0 | 0 |

Figure 3 shows the pulses of the clock signal CLK which are appropriate for clocking the flip flop of figure 2. Because the flip of figure 2 works on both edges of the clock pulses, the duty cycle of the clock signal CLK should be, as shown in figure 3, 2d, i.e. twice as long as the pulses d of the clock pulses. A clock signal CLK with such a duty cycle ensures that the flip flops are switched at an equal pace.

Figure 4 shows a more detailed circuit diagram of the flip flop of figure 2. The data signals D are input into an inverter 40 which is connected to input inverters 42, 44 of the latches 30 and 32 respectively. The input inverter 42 is connected to the input of a transfer gate 46 of the latch 30, the output of which transfer gate 46 is connected to an output inverter 48 of the latch 30. A transfer gate 50 is the main part of a holding loop of the latch 30, the output of which transfer gate 50 is connected to the output inverter 48, and the output of the output inverter 48 is fed back to an input inverter 52 connected to the input of transfer gate 50.

The outputs of output inverters 48, 58 are fed to the inputs of transfer gates 70, 72 which form the main parts of the multiplexer circuit 34, and the outputs of transfer gates 70, 72 are fed to an output inverter 74 the output signal of which is the output signal Q of the flip flop of figure 4.

The clock signal CLK is fed through an inverter to create the inverted output signal CLK' and the inverted clock signal CLK' is fed to a further inverter 78 which outputs the original clock signal CLK. The clock signal CLK and the inverted clock signal CLK' are fed to the latches 30, 32 and the multiplexer circuit 34 as shown in figure 4.

The circuit of figure 4 works as follows. Supposing the inverted clock signal CLK' is at "zero", the transfer gate 46 in the latch 30 and the transfer gate 72 in the multiplexer circuit 34 are transparent which means that the value at the transfer gate 46 is stored in the transfer gate 50 and the value stored in transfer gate 56 is output through transfer gate 72 and inverter 74. When the inverted clock signal CLK' is "zero" the original clock signal CLK is "one". Therefore, transfer gate 74 is open when the inverted clock signal CLK' is ,,zero".

When the inverted clock signal CLK' is "one", transfer gates 50, 60 and 70 are transparent. In this situation, the value of the data signal D arriving at the inverter 44 is stored in transfer gate 56 and the value stored in transfer gate 50 is transferred through transfer gate 70 to the output inverter 74. It is apparent from this operation of the circuit of figure 4, that the flip flop switches at the edge of the clock pulses going from "zero" to "one" (rising edge) as well as at the edge of the clock pulses going from "one" to "zero" (falling edge) of the clock pulse.

## Claims

1. Method for operating an ASIC device having a clock driver, a clock tree system and load circuits being supplied with a clock signal from the clock driver through the clock tree system, the clock signal having clock pulses with a rising and a falling edge, which method comprises:
- providing flip flops which are operated by both edges of the clock pulses, as load circuits and
- supplying a clock signal having a duty cycle twice as long as the pulse width of the clock pulses.

2. ASIC device having a clock driver, a clock tree system and load circuits being supplied with a clock signal having clock pulses with a rising and a falling edge, from the clock driver through the clock tree system, comprises:
- flip flops (18) which are operated by both edges of the clock pulses, as load circuit devices, and
- a clock driver (12) which is designed such that it supplies a clock signal having a duty cycle twice as long as the pulse width of the clock pulses.

3. Flip flop for use in an ASIC device having a clock driver (12), a clock tree system (2) and load circuits (18) being supplied with a clock signal having clock pulses with a rising and a falling edge, from the clock driver through the clock tree system, wherein the flip flop is adapted to be operated by both edges of the clock pulses.

4. Flip flop according to claim 3, wherein the flip flop comprises two latch circuits (30, 32) connected in parallel to each other, and a multiplexer circuit (34), one of the latch circuits becoming transparent on occurrence of the rising edge of the clock pulse, the other one of the latch circuits becoming transparent on occurrence of the falling edge of the clock pulse, and the multiplexer circuit (34) being supplied at its inputs with output signals of the latch circuits (30, 32) and being clocked by the clock signal.

5. Flip flop according to claim 3, characterized in that transparent D-flip flops are used for the latch circuits.
